# FASCICULE DE BREVET EUROPEEN

(11) **EP 2 715 480 B1**
(45) Date de publication et mention de la délivrance du brevet: **04.07.2018**
(21) Numéro de dépôt: 12756793.1
(22) Date de dépôt: 27.08.2012
(51) Int. Cl.: G06F 1/20, G06F 1/18, H05K 7/20, G06F 1/16

(54) **CONTENEUR AMENAGE EN UNE INFRASTRUCTURE TECHNIQUE**
CONTAINER AUSGERÜSTET FÜR EINE TECHNISCHE INFRASTRUKTUR
CONTAINER EQUIPPED FOR A TECHNICAL INFRASTRUCTURE

(30) Priorité: 01.09.2011 FR 1157760
(43) Date de publication de la demande: 09.04.2014
(60) Demande divisionnaire: 17194131.3
(73) Titulaire: OVH, 59100 Roubaix (FR)
(72) Inventeur: KLABA, Miroslaw, F-59100 Roubaix (FR)
(74) Mandataire: Therias, Philippe
(86) Numéro de dépôt international: PCT/FR2012/051938
(87) Numéro de publication internationale: WO 2013/030501

(56) Documents cités:
- WO-A1-2010/040868
- FR-A1- 2 895 209
- US-A1- 2006 187 636
- US-A1- 2006 187 636
- US-A1- 2010 110 626
- US-A1- 2010 110 626
- US-B1- 7 278 273
- US-B1- 7 278 273
- US-B1- 7 430 118
- US-B1- 7 430 118

## Description

La présente invention concerne les infrastructures techniques, et plus particulièrement l'aménagement de ces infrastructures.

On désigne ici par « infrastructure technique » toute infrastructure immobilière dédiée aux technologies de l'information et de la communication tel qu'un centre de calcul/centre de données (data center), un centre d'hébergement, un centre de repli (back-up site), ou un hôtel de télécommunication (telecom/carrier hotel, ou server-farm). Ces infrastructures prennent généralement la forme de salles (ou bâtiments) informatiques comprenant, à titre d'exemples non-exhaustifs, des équipements de télécommunications, des serveurs, des systèmes de stockage, des systèmes d'alimentation, des systèmes de refroidissement, des onduleurs, des systèmes de distribution électrique, et des postes de travail.

Par ailleurs, on entend par « aménagement » d'une infrastructure technique sa mise en condition afin de répondre à l'ensemble des exigences durant son cycle de vie (c.à.d. conception, déploiement, fonctionnement, maintenance). Parmi ces exigences, on cite :
- l'efficacité énergétique et le respect de l'environnement: pousser le PUE (Power Usage Effectiveness) d'une infrastructure technique à des ratios plus optimisés pour des raisons économiques ainsi qu'environnementales ;
- la rapidité de déploiement : pourvoir répondre rapidement à des demandes urgentes et temporaires en optimisant le temps nécessaire pour la mise en service d'une infrastructure technique ;
- la portabilité/mobilité: pouvoir transporter une infrastructure technique depuis ou vers n'importe quel endroit face aux aléas naturels, politiques ou sociaux (émeutes, séismes, tempêtes de neige, cyclones, inondations, incendies par exemple) ;
- la modularité : pouvoir restructurer/étendre à tout moment une infrastructure technique.

Ces exigences ont suscité l'émergence de nouvelles conceptions pour les infrastructures techniques, et particulièrement pour les centres de données (data center).

On distingue, dans ce domaine, la conteneurisation (c'est-à-dire, la mise en conteneur) des centres de données. On entend, ici, par « conteneur » (ou container, en anglais), le caisson métallique conventionnel, conçu en forme de parallélépipède pour le transport de marchandises. En effet, des salles informatiques aménagées dans des conteneurs équipées de systèmes de refroidissement sont d'ores et déjà disponibles.

Plus généralement, des contenants métalliques (désignés dans l'état de la technique par des modules) spécialement conçus pour loger des salles informatiques et équipés par des systèmes de refroidissement sont aussi proposés.

Cependant, les solutions existantes sont imparfaites, notamment en raison de leur non-optimalité. Ces conteneurs/modules affichent des limites, particulièrement en termes d'efficacité énergétique et du respect de l'environnement.

Par exemple, US2010110626 A1 se rapporte à un système d'information agencé dans un conteneur aménagé en une infrastructure technique. Ce document s'attaque au problème d'efficacité énergétique, notamment en matière de refroidissement des infrastructures techniques mises en conteneur et propose, pour cela, un aménagement particulier du conteneur.

En effet, avec des équipements informatiques de plus en plus énergivores et à une densité de puissance sans cesse croissante face à des systèmes de refroidissement poussés aux limites de leur capacités,
- aménager une salle informatique dans un conteneur pour sa transportabilité sans considération de son PUE ; ou
- aménager un conteneur de la même manière qu'une salle informatique conventionnelle
risque de compromettre le coût global (PUE) des centres de données, ainsi qu'impacter l'environnement.

Un objet de la présente invention est de remédier aux inconvénients précités.

Un autre objet de la présente invention est d'améliorer l'efficacité énergétique d'un centre de données (data center) aménagé dans un conteneur.

Un objet de la présente invention est d'optimiser l'aménagement d'un conteneur afin de concevoir des centres de données plus économes en énergie.

Un autre objet de la présente invention est d'améliorer l'empreinte écologique d'un data center.

Un autre objet de la présente invention est de tenir compte des paramètres environnementaux dans l'aménagement des infrastructures techniques.

Un autre objet de la présente invention est d'éviter le recours à une lourde infrastructure électrique pour le refroidissement d'une infrastructure technique.

Un autre objet de la présente invention est de repenser, face aux contraintes énergétiques, l'agencement des salles informatiques aménagées dans des conteneurs.

Un autre objet de la présente invention est de proposer des architectures d'infrastructures techniques intégrant des ressources durables.

Un autre objet de la présente invention est d'intégrer la dimension environnementale dans la conception des centres de données.

A cette fin, l'invention se rapporte, selon un premier aspect, à un conteneur aménagé en une infrastructure technique comprenant
- sur une face latérale longitudinale, au moins une ouverture agencée pour permettre l'entrée d'air vers l'intérieur du conteneur ;
- sur la face latérale longitudinale opposée, au moins un ventilateur agencé pour ressortir l'air de l'intérieur vers l'extérieur du conteneur, la dite au moins une ouverture et le dit au moins un ventilateur étant verticalement décalés à deux hauteurs différentes des deux faces latérales longitudinales opposées, ledit au moins un ventilateur étant à une hauteur supérieure par rapport à ladite au moins une ouverture;
- des baies informatiques disposées au milieu du conteneur le long de son axe longitudinal.

L'invention propose, selon un deuxième aspect, un centre de données comprenant une pluralité de conteneurs aménagés en une infrastructure technique telle que définie ci-dessus, ces conteneurs aménagés étant agencés en forme de cheminée dont la cavité est ouverte vers le haut.

D'autres caractéristiques et avantages de l'invention apparaîtront plus clairement et de manière concrète à la lecture de la description ci-après de modes de réalisation préférés, laquelle est faite en référence aux dessins annexés dans lesquels :
- les figures 1 et 2 illustrent schématiquement, respectivement, une vue de profil et une vue de côté en coupe d'un conteneur aménagé selon un mode de réalisation ;
- la figure 3 illustre schématiquement une architecture d'un centre de données obtenu par agencement de conteneurs aménagés selon un mode de réalisation.

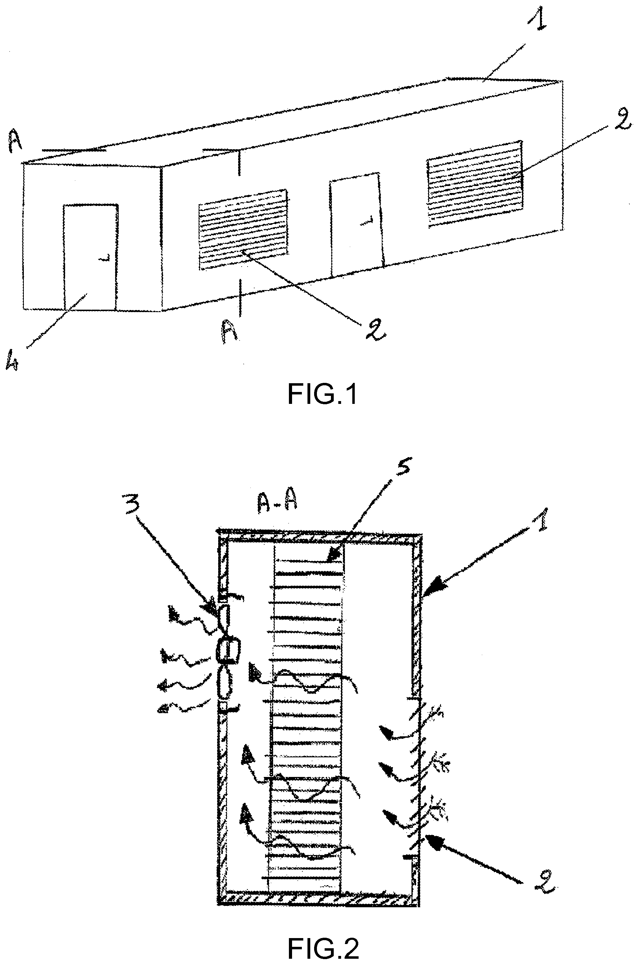

On se référant aux figures 1 et 2, des transformations sont apportées au conteneur **1** pour comprendre:
- sur une face latérale longitudinale, une pluralité d'ouvertures **2** (notamment, sous forme de ventelles) quadrangulaire agencées pour permettre l'entrée d'air vers l'intérieur du conteneur **1;**
- sur la face latérale longitudinale opposée, une pluralité de ventilateurs **3** agencés pour ressortir l'air de l'intérieur vers l'extérieur du conteneur **1;** et
- au moins une porte **4.**

Comme illustré sur la vue de profil du conteneur **1** sur la figure 2, des baies informatiques **5** (ou, des racks informatiques) sont disposées au milieu du conteneur le long de son axe longitudinal, de sorte à former deux couloirs vides longitudinaux. Par conséquent, un couloir existe de part et d'autre des baies informatiques **5** permettant l'accès aux équipements informatiques sans aucune difficulté. Notamment, aucune restriction n'est faite sur le type des baies **5** qui peuvent être de toute provenance.

Ainsi que visible sur la figure 2, les ventilateurs **3** et les ouvertures **2** sont verticalement décalés à deux hauteurs différentes des deux faces latérales longitudinales opposées. Les ventilateurs **3** sont à une hauteur supérieure afin de ressortir l'air chaud, et les ouvertures **2** sont à une hauteur inférieure afin de refroidir au mieux les baies avec l'air entrant supposé à une température inférieure à celle de l'intérieur du conteneur.

La figure 2 illustre, en outre, l'entrée de l'air d'amont en aval du conteneur aménagé **1,** soit de droite à gauche sur la figure 2. On assiste, en effet, à
- l'entrée de l'air ambiant, sous la force du vent ou par la dépression générée par les ventilateurs **3** ;
- l'écoulement de l'air à travers les équipements informatiques des racks **5** ;
- l'évacuation vers l'extérieur du conteneur **1** de l'air chaud par les ventilateurs **3.**

Avantageusement, les deux couloirs de part et d'autre des baies informatiques **5** favorisent, respectivement,
- l'arrivée uniforme des flux d'air perpendiculairement à la direction d'agencement des baies informatiques **5** ce qui représente une exposition favorable au refroidissement des équipements informatiques ;
- l'échappement de l'air chaud via les ventilateurs **3** opérationnels dans le sens et la direction des flux d'air chaud.

Il en résulte que la dépression générée par les ventilateurs **3** à l'entrée des ouvertures **2** (c.à.d. des ventelles), les deux couloirs vides de part et d'autre des racks informatiques **5,** et les ventilateurs **3** sur la face opposée assurent une ventilation naturelle de la salle informatique aménagée dans le conteneur **1.**

Avantageusement, cet inter-agencement des ouvertures **2,** des ventilateurs **3,** et baies informatiques **5** favorise un refroidissement optimal à l'air ambiant de la salle informatique aménagée dans le conteneur **1.**

En effet, cet inter-agencement des ouvertures **2,** des ventilateurs **3** et des baies informatiques **5** a pour effet technique une meilleure ventilation des racks disposés perpendiculairement à la direction de propagation du flux d'air entrant. La disposition des ventilateurs **3** sur la face opposée de celle des ouvertures **2** favorisent la création d'un courant d'air permettant la ventilation naturelle des baies informatiques **5.**

Par conséquent, en contribuant à l'amélioration de l'efficacité énergétique du data center, l'inter-agencement des ces éléments (ouvertures, ventilateurs, baies informatiques) est notamment fonctionnel.

Par conséquent, le centre de données aménagées dans le conteneur **1** est complètement refroidi à l'aide de l'air extérieur ambiant.

De préférence, des filtres - juxtaposés aux ouvertures **2** - filtrent l'air entrant des poussières, des gaz nocifs, et régulent son degré d'humidité. Ces filtres sont notamment utiles lorsque le conteneur **1** est installé dans des zones trop humides ou à forte circulation de poussières ou de gaz nocifs (zone côtière, chantier, zone industrielle par exemple). Ces filtres sont configurés, en particulier, pour maintenir le degré d'humidité de l'air entrant dans un intervalle prédéfini ou en cas de besoin déclencher un dispositif de contrôle pour maintenir le degré d'humidité dans cet intervalle.

De préférence, les ouvertures **3** sont contrôlées par un système de régulation automatique des degrés d'ouverture (des ventelles, par exemples), et par conséquent du débit d'air entrant, en fonction de la charge de refroidissement requise.

Il est à noter que le nombre et les dimensions des ouvertures **2,** ainsi que ceux des ventilateurs **3** sont choisis de sorte à tenir compte d'une pluralité de facteurs dont on cite l'environnement de déploiement et la charge informatique de l'infrastructure technique.

Il est à noter que des systèmes de refroidissement supplémentaires peuvent être combinés au système de refroidissement à l'air libre décrit ci-dessus. A titre d'exemple, des systèmes de refroidissement par détente de gaz/liquide, à l'eau glacée, ou à l'eau peuvent être adoptés en combinaison, en option ou en solution de repli au système de refroidissement à l'air libre. En combinaison avec un système de refroidissement liquide (à l'eau par exemple), il en résulte la coexistence de deux systèmes de refroidissement du centre de données (ou le centre d'hébergement) aménagé dans le conteneur **1.**

Le conteneur aménagé **1** comprend, en outre, des moyens prévus pour la sécurité, la sécurité incendie, et la gestion des risques (capteurs, systèmes de détection de fuite d'eau et de fumée par exemple).

Dans un mode de réalisation, le conteneur aménagée 1 est disposé de sorte que son intérieur peut communiquer avec l'intérieur d'au moins un autre conteneur aménage **1,** et est par conséquent extensible.

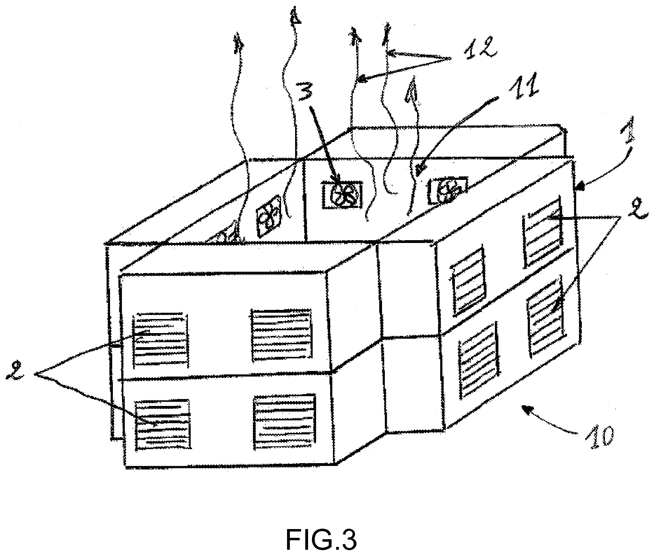

Dans un mode de réalisation illustré par la figure 3, une pluralité de conteneurs aménagés **1** sont organisés en forme de cheminée. L'infrastructure technique résultante **10** constitue ainsi un bâtiment creux ayant une cavité **11** ouvert vers le haut.

Les ventilateurs **3,** donnant dans la cavité **11** du data center **1,** permettent d'acheminer l'air chaud vers la cavité **11,** qui a son tour, par effet de cheminée, l'évacue vers l'extérieur. L'effet de cheminée est dû à l'écart de température entre l'air chaud à l'intérieur du centre de données (l'infrastructure technique résultante) **10** et l'air froid de l'extérieur, lequel provoque un déplacement ascendant **12** d'air en provenance des ventilateurs **3.**

Avantageusement, la combinaison de l'effet de cheminée produit par la cavité **11** et de la force du vent à l'entrée des ouvertures **2,** aménagées dans les faces latérales des conteneurs aménagés **1,** assurent une ventilation naturelle du centre de données **10.** Autrement dit, l'air est naturellement mis en mouvement au travers des conteneurs aménagés **1** de l'infrastructure technique **10.** En effet, l'air soufflé par les ouvertures murales **2** vers l'intérieur de l'infrastructure technique **10** ressort, via les ventilateurs **3,** par tirage thermique vers la cavité **11.**

De préférence, la cavité **11** est polygonale convexe, notamment rectangulaire ou carrée. En variante, la cavité **11** est polygonale concave ou croisé.

Le système qui vient d'être décrit présente un certain nombre d'avantages. Il permet en effet :
- une mise à disposition rapide d'une infrastructure technique performante et économique ;
- si la température ambiante de l'endroit de déploiement est inférieure à une valeur prédéfinie, une amélioration considérable de l'efficacité énergétique des infrastructures techniques ;
- une réduction du coût d'installation et d'exploitation par rapport à celui des centres de données traditionnels;
- la construction de bâtiments informatiques écologiques.

Il est à noter que le terme « conteneur » recouvre ici tout caisson métallique semblable au conteneur conventionnel sans qu'il n'ait nécessairement les dimensions standardisées d'un conteneur de marchandise.

La description ci-dessus est faite en référence à une salle informatique ou un centre de données (data center), mais cet exemple d'infrastructure technique n'est bien entendu pas limitatif et peut se rapporter à toute autre infrastructure immobilière dédiée aux technologies de l'information et de la communication.

## Revendications

1. Conteneur aménagé (**1**) en une infrastructure technique comprenant
- sur une face latérale longitudinale, au moins une ouverture(**2**) agencée pour permettre l'entrée d'air vers l'intérieur du conteneur (**1**);
- sur la face latérale longitudinale opposée, au moins un ventilateur (**3**) agencé pour ressortir l'air de l'intérieur vers l'extérieur du conteneur (**1**), la dite au moins une ouverture (**2**) et le dit au moins un ventilateur (**3**) étant verticalement décalés à deux hauteurs différentes des deux faces latérales longitudinales opposées, ledit au moins un ventilateur étant à une hauteur supérieure par rapport à ladite au moins une ouverture;
- des baies informatiques (**5**) disposées au milieu du conteneur (**1**) le long de son axe longitudinal.

2. Conteneur selon la revendication précédente, **caractérisé en ce qu'**il comprend en outre au moins un filtre agencé pour filtrer l'air entrant.

3. Conteneur selon la revendication précédente, **caractérisé en ce que** le filtre est agencé pour réguler le degré d'humidité de l'air entrant.

4. Conteneur selon l'une quelconque des revendications précédentes, **caractérisé en ce qu'**il comprend en outre un système de refroidissement à l'eau.

5. Centre de données (**10**) comprenant une pluralité de conteneurs aménagés (**1**) en une infrastructure technique telle que définie dans l'une quelconques des revendications 1 à 4.

6. Centre de données (**10**) selon la revendication précédente, **caractérisée en ce que** les conteneurs aménagés (**1**) sont agencés en forme de cheminée dont la cavité (**11**) est ouverte vers le haut.

## Patentansprüche

1. Als eine technische Infrastruktur eingerichteter Container (1), umfassend
- an einer Längsseitenfläche wenigstens eine Öffnung (2), die dazu ausgelegt ist, den Eintritt von Luft in das Innere des Containers (1) zu ermöglichen;
- an der gegenüberliegenden Längsseitenfläche wenigstens einen Ventilator (3), der dazu ausgelegt ist, die Luft aus dem Inneren des Containers (1) nach außen auszustoßen, wobei die wenigstens eine Öffnung (2) und der wenigstens eine Ventilator (3) vertikal auf zwei verschiedenen Höhen der zwei gegenüberliegenden Längsseitenflächen versetzt sind, wobei sich der wenigstens eine Ventilator auf einer größeren Höhe im Verhältnis zu der wenigstens einen Öffnung befindet;
- Racks (5), die in der Mitte des Containers (1) entlang seiner Längsachse angeordnet sind.

2. Container nach dem vorhergehenden Anspruch, **dadurch gekennzeichnet, dass** er ferner wenigstens ein Filter umfasst, das dazu ausgelegt ist, die Zuluft zu filtern.

3. Container nach dem vorhergehenden Anspruch, **dadurch gekennzeichnet, dass** das Filter dazu ausgelegt ist, den Feuchtigkeitsgrad der Zuluft zu regulieren.

4. Container nach einem der vorhergehenden Ansprüche, **dadurch gekennzeichnet, dass** er ferner ein Wasserkühlsystem umfasst.

5. Rechenzentrum (10), umfassend eine Vielzahl von als eine technische Infrastruktur eingerichteten Containern (1) nach einem der Ansprüche 1 bis 4.

6. Rechenzentrum (10) nach dem vorhergehenden Anspruch, **dadurch gekennzeichnet, dass** die eingerichteten Container (1) in Form eines Kamins ausgelegt sind, dessen Hohlraum (11) nach oben hin offen ist.

## Claims

1. A container (1) equipped for a technical infrastructure including
- on a longitudinal lateral surface, at least one opening (2) arranged for allowing the entry of air to the interior of the container (1);
- on an opposite longitudinal lateral surface, at least one fan (3) arranged for taking the air out from the interior to the exterior of the container (1), said at least one opening (2) and said at least one fan (3) being vertically offset at two different heights of the two opposite longitudinal lateral surfaces, said at least one fan being at a greater height with respect to said at least one opening;
- computer bays (5) arranged in the middle of the container (1) along its longitudinal axis.

2. The container according to the preceding claim, **characterized in that** it moreover includes at least one filter arranged for filtering the entering air.

3. The container according to the preceding claim, **characterized in that** the filter is arranged for regulating the moisture content of the entering air.

4. The container according to any one of the preceding claims, **characterized in that** it moreover includes a system for cooling by water.

5. A data center (10) including a plurality of converted containers (1) in the form of a technical infrastructure as defined in any one of claims 1 to 4.

6. The data center (10) according to the preceding claim, **characterized in that** the converted containers (1) are arranged in the form of a shaft of which the cavity (11) is open upwards.
